# EUROPEAN PATENT SPECIFICATION

(11) **EP 1 058 315 B1**
(45) Date of publication and mention of the grant of the patent: **27.08.2003**
(21) Application number: 99830340.8
(22) Date of filing: 03.06.1999
(51) Int. Cl.: H01L 29/06, H01L 29/41

(54) **Edge termination of semiconductor devices for high voltages with capacitive voltage divider**
Randabschluss von Hochspannungs-Halbleiterbauelementen mit einem kapazitiven Spannungsteiler
Terminaison de bord de dispositifs semi-conducteurs à haute tension comprenant une diviseur de tension capacitif

(43) Date of publication of application: 06.12.2000
(73) Proprietor: STMicroelectronics S.r.l., 20041 Agrate Brianza (Milano) (IT)
(72) Inventor: Grimaldi, Antonio, 95030 Mascalucia (CT) (IT); Schillaci, Antonino, 98125 Messina (IT); Ferla, Giuseppe, 95126 Catania (IT)
(74) Representative: Mittler, Enrico

(56) References cited:
- EP-A- 0 566 179
- EP-A- 0 687 011
- GB-A- 2 077 493
- GB-A- 2 205 682
- US-A- 4 614 959
- TERSHIMA T ET AL: "OVER 1000V N-CH LDMOSFET AND P-CH LIGBT WITH JI RESURF STRUCTURE AND MULTIPLE FLOATING FIELD PLATE" PROCEEDINGS OF THE 7TH. INTERNATIONAL SYMPOSIUM ON POWER SEMICONDUCTOR DEVICES AND IC'S. (ISPSD), YOKOHAMA, MAY 23 - 25, 1995, no. SYMP. 7, 23 May 1995 (1995-05-23), pages 455-459, XP000594273 INSTITUTE OF ELECTRICAL AND ELECTRONICS ENGINEERS ISBN: 0-7803-2619-9
- PATENT ABSTRACTS OF JAPAN vol. 012, no. 013 (E-573), 14 January 1988 (1988-01-14) & JP 62 173764 A (MATSUSHITA ELECTRIC WORKS LTD), 30 July 1987 (1987-07-30)

## Description

The present invention relates to an improvement of semiconductor devices for high voltages, particularly of power devices in MOS technology. More particularly the invention relates to an improvement of edge termination of said devices with a capacitive voltage divider.

The main problem of the raggedness of the power devices in MOS technology at high operating voltages lies essentially in breakdown voltage of the MOS devices. The phenomenon of the MOS devices' breakdown lies essentially in the less resistive region, which is in the edge of the junction between the body pocket and the underlying drain layer. In fact the equipotential lines of the electric field thicken in the aforesaid zone causing the device's breakdown at a lower voltage than the theoretical breakdown voltage.

A typical technology to improve such behaviour of power devices in MOS technology consists in the deposition of a metal layer, in a step-like structure (the metal is first deposited over a thin oxide, then over a thicker oxide), in correspondence of the device's periphery, in order to avoid the thickening of the electric field's lines at the edge of the junction between the body pocket and the underlying drain layer.

The more recent prior art presents a particular manufacturing of the power device in MOS technology, wherein besides the double step metallization over a thin oxide layer and a double layer formed by oxide and polysilicon, a guard-ring is added. Such ring is constituted by a P+ pocket where before a thick field oxide layer is placed and then a silox layer is placed, where the silox is a insulating material, usually silicon dioxide doped by phosphorus. The aim of this multi-layer of silicon oxide, polysilicon, silox and aluminium is to make a bridge structure which widens the electric field's lines of the device's body. The polysilicon is connected or capacitively coupled with the aluminium layer. The silox layer serves to prevent the polarization of the layers under influence of lateral high fields through the device's surface. The use of the P+ pocket serves to planarize the electric field's lines; in fact the P+ pocket has a conductivity opposite to the N- epitaxial layer wherein it is formed in order to allow an extension of the electric field's lines parallelly to the device's surface.

The use of the field-plates with a guard-ring presents a limit for the high operating voltage the device is submitted to.

EP-A- 0 687 011 discloses capacitively coupled field plates.

In view of the state of the art described, it is an object of the present invention to provide a technology for the manufacturing of a semiconductor device with an edge termination which allows to resist to the high operating voltages it is submitted to.

According to the present invention, such object is attained by a semiconductor device for high voltages as defined in claim 1. level interposed by a dielectric layer underlying said metal layers, said metal

Thanks to the present invention it is possible to form a semiconductor device for high voltages allowing to obtain, thanks to existence of a voltage divider, a higher breakdown voltage.

The features and the advantages of the present invention will be made evident by the following detailed description of a particular embodiment, illustrated as not limiting example in the annexed drawings, wherein:
Figure 1 is a circuit schematic view of a device according to an embodiment of the present invention;
   Figure 1a is a circuit schematic view of a device in breakdown state according the embodiment of the present invention;
   Figure 2 is the layout of the edge termination of the device according the embodiment of the present invention;
   Figure 3 shows the cross-section III-III of figure 2;
   Figure 4 shows the cross-section IV-IV of figure 2;
   Figure 5 is a schematic top-plan view of the chip according to an embodiment of the present invention.

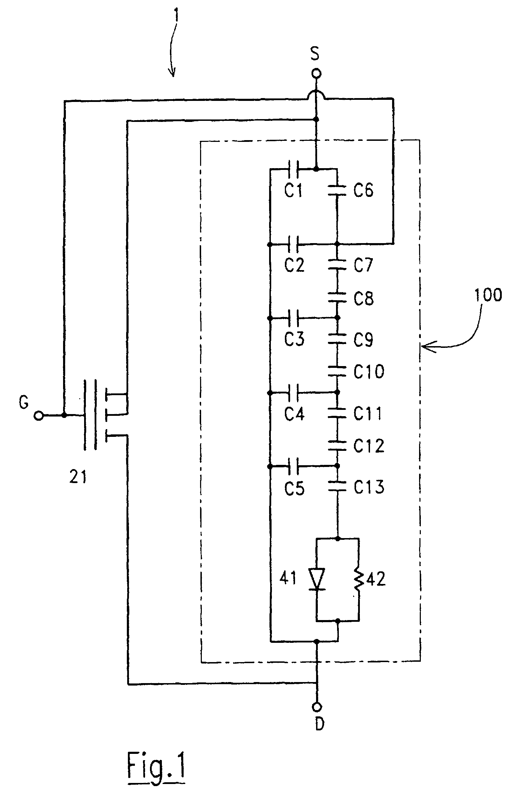

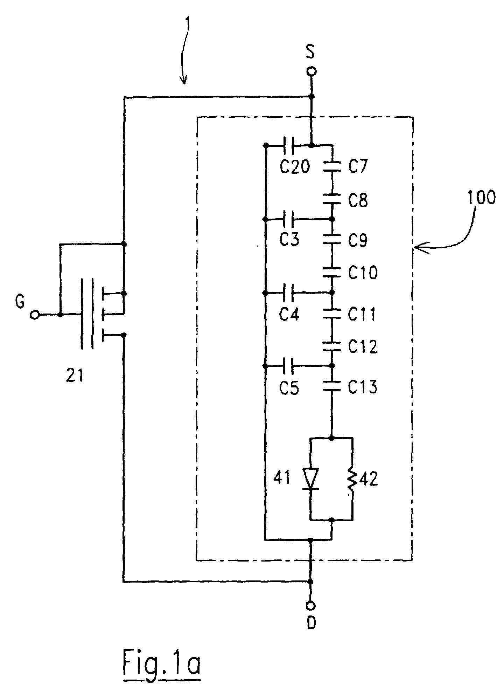

With reference to the annexed drawings, and specifically to figure 1, a circuit schematic view of a device 1 is shown. This device 1 is constituted by a power MOSFET 21 connected to an edge termination 100, according to an embodiment of the present invention. The power MOSFET transistor 21 is connected to a capacitive circuit. In fact the source S and drain D terminals of the power MOSFET transistor 21 are connected to capacitor couples in series according a T structure. The S terminal is connected both to one capacitor C1 extremity and to one capacitor C6 extremity; the capacitor C1 has the other extremity connected to drain.D terminal while the capacitor C6 has the other extremity connected to one capacitor C2 extremity, to one capacitor C7 extremity, and to gate G terminal of the power MOSFET transistor 21. The capacitor C2 has the other extremity connected to D terminal while the capacitor C7 has the other extremity connected to one capacitor C8 extremity, the capacitor C8 has the other extremity connected both to one capacitor C3 extremity and to a capacitor C9 extremity and so continuing to arrive to a capacitor C13 and to a capacitor C5. The capacitor C5 is connected at one extremity to a capacitor C12 and in the other extremity to the drain terminal of the transistor 21 while the capacitor C13 is connected in one extremity to capacitor C12 and at the other extremity to a diode 41 and a resistance 42 both connected to the drain terminal D of the power MOSFET transistor 21. The capacitor circuit forms a capacitive divider which allows to divide the voltage between the drain terminal and the source terminal of the power transistor 21.

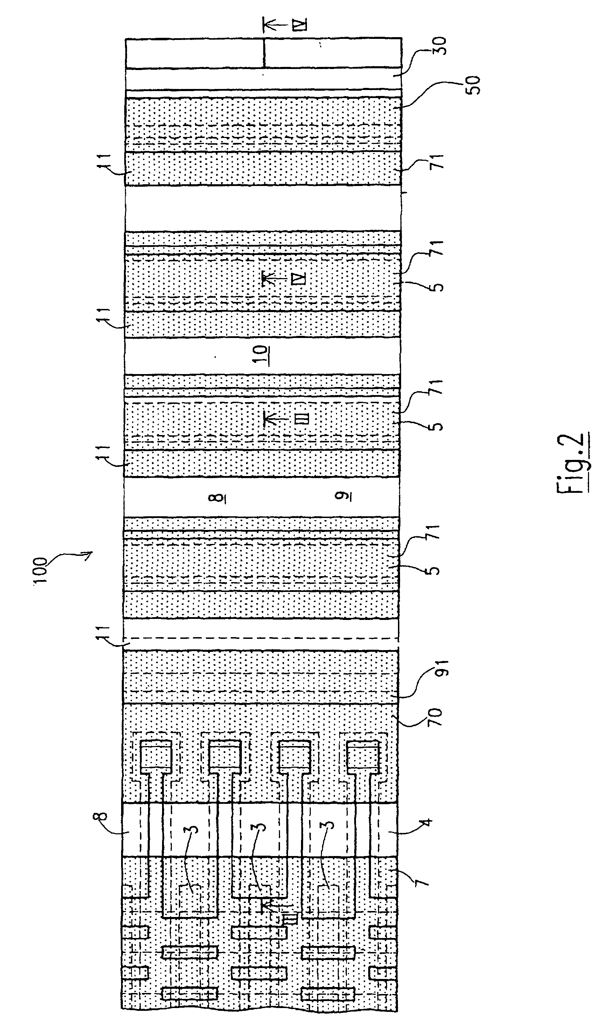

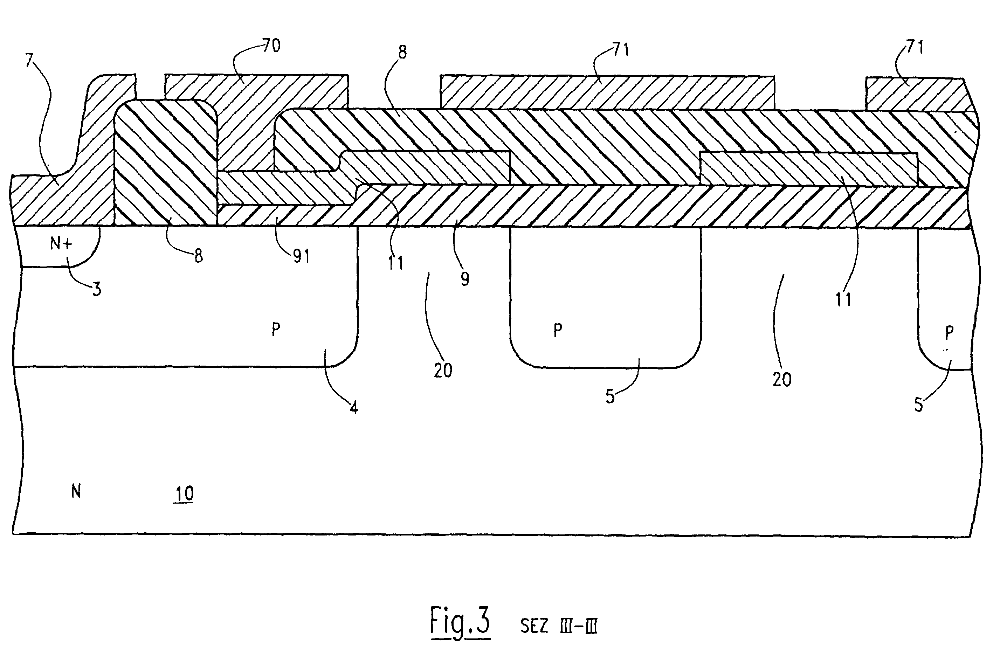

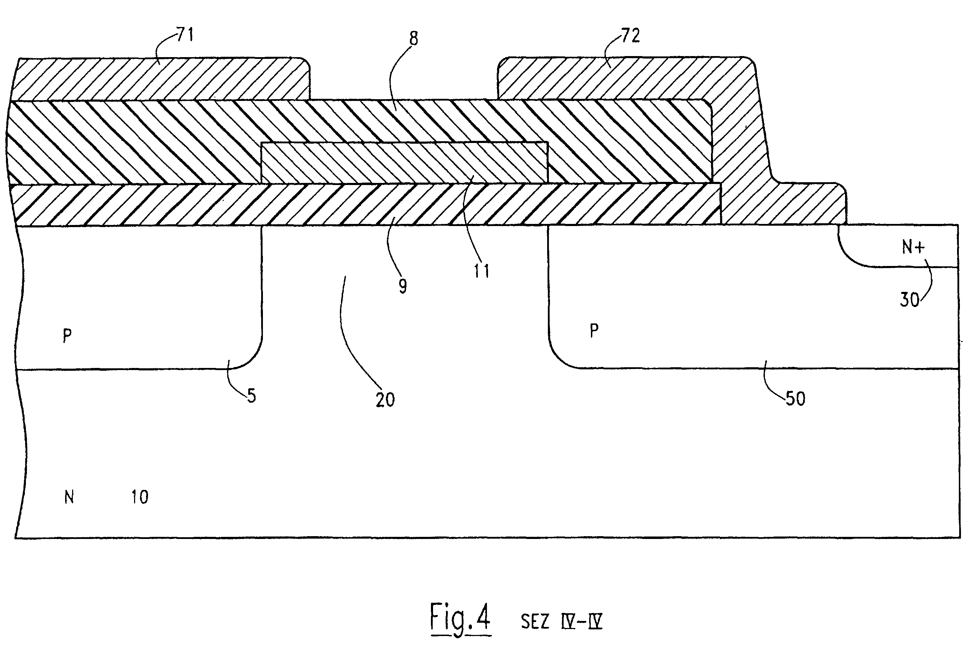

In figure 2 the layout is shown of the edge termination of the device 1 according to invention. With reference to figure 2 and to figure 3 which shows a cross-sectional view of the edge termination 100 along a line III-III, in a semiconductor layer 10 of N type which acts as drain for the power MOSFET transistor 21 and wherein the elementary units of the same transistor are formed, silicon stripes 4, 5, 50 of P type alternated by portions of the same layer 10 are formed. In a peripheral zone the P silicon stripe 4 merged with body region of the power MOSFET transistor 21 is present. Such stripe 4 contains a silicon region 3 with high concentration of N type dopant, which represents the source region of the transistor 21. At the free surface of the stripe 4, in periphery, a metal layer 7 is placed, which allows to contact both the body and sourcc of the transistor 21. In a superficial succession of layers superimposed on silicon layer 4, the metal layer 7 is followed by a first dielectric layer 8 followed by a silicon oxide layer 9. Such silicon oxide layer 9 having a thin thickness over the surface of the stripes 4, extends, with a higher thickness, over the layer 10 and also over the P silicon stripes 5, substantially to a zone in correspondence of the half the P silicon stripe 50 shown more in detail in figure 4. A first polysilicon layer 11 is placed over the silicon oxide layer 9 extending from the beginning of the oxide layer 9 over the silicon layer 4, to a zone in correspondence of the beginning of the first P silicon stripe 5. A second polysilicon layer 11 extends from a zone in correspondence of the end of the first P silicon stripe to a zone in correspondence of the beginning of the second P silicon stripe 5. A metal layer 70 is placed in the first polysilicon layer in correspondence of the silicon stripe 4, representing a gate metal ring, and a second dielectric layer 8 is placed in correspondence of the end of the stripe 4. Such second dielectric layer 8, having a thickness equal to a higher thickness of the oxide layer 9, extends both over the polysilicon layers and over the same oxide layer 9 to a zone next to the half the silicon stripe 50. Metal layers 71 are placed in the second dielectric layer 8 extending in a zone overlapped to the silicon regions 5 and in correspondence of the half of the portions 20 adjacent to said stripes 5.

The junction between the silicon stripe 4, contacted by the source terminal of the transistor 21, and the N layer 10 forms the capacitor C1 while the capacitor C6 is formed by the first polysilicon layer 11, by the stripe 4 and by thin portion 91 of the oxide layer 9 interposed between them. Also the first polysilicon layer 11 with the portion 20 of the layer 10 and the portion of the oxide layer 9 interposed forms the capacitor C2 while it with the metal layer 71 and the portion of the second dielectric layer 8 interposed forms the capacitor C7. The metal layer 71 with the second polysilicon layer 11 and the portion of the second dielectric layer 8 interposed forms the capacitor C8. Similarly the capacitor couples C9, C10 and C11, C12 are formed as the capacitor couple C7, C8 while the capacitors C3, C4, C5 are formed similarly to the capacitor C2.

The end of the layout in figure 2, shown in more detail in figure 4, comprises a P silicon stripe 50, located inside the layer 10. Such layer 50 contains a silicon stripe 30 with high concentration of N type dopant, which forms the drain contact of the power transistor 21. However this contact is made by defects inside the "scribe line" and these defects form also a resistance 42. A third polysilicon layer 11 is placed in the oxide layer 9 in correspondence of the portion 20 interposed between a third P silicon stripe 5 and the stripe 50. A metal layer 72 is placed over the second dielectric layer 8, in a zone substantially in correspondence of the half of the portion 20 , before of the stripe 50, and over one part of the free surface of the stripes 40 and 30. Such metal layer 72 together with third polysilicon layer 11 and the dielectric interposed, forms the capacitor C13, which is connected with the drain terminal of the transistor 21 by the resistance 42 and the diode 41 which is formed by junction between the silicon stripe 50 and the silicon layer 10.

In breakdown state, the power MOSFET transistor 21 is off and consequently the voltages of its gate G and source S terminals assume an equal potential. Therefore, in the edge termination 100 the capacitor C6 is short-circuited and a new capacitor C20 is formed by the parallel of two capacitors C1 and C2, as described in figure 1a.

The P stripes 5 allow to planarize the electric field lines when the device 1 is exposed to a high reverse-bias polarization voltage between drain and source of the power transistor 21. So the thickening of the electric field's lines in the body 4 of the power transistor is avoided, in order to allow an increase of the breakdown voltage of the device 1. Also the edge termination constituted by the capacitors circuit allows a voltage partition at the device's surface. The presence of the tick oxide layers allows the electric field's lines to come out at the surface avoiding thickening in the body region of the power transistor 21.

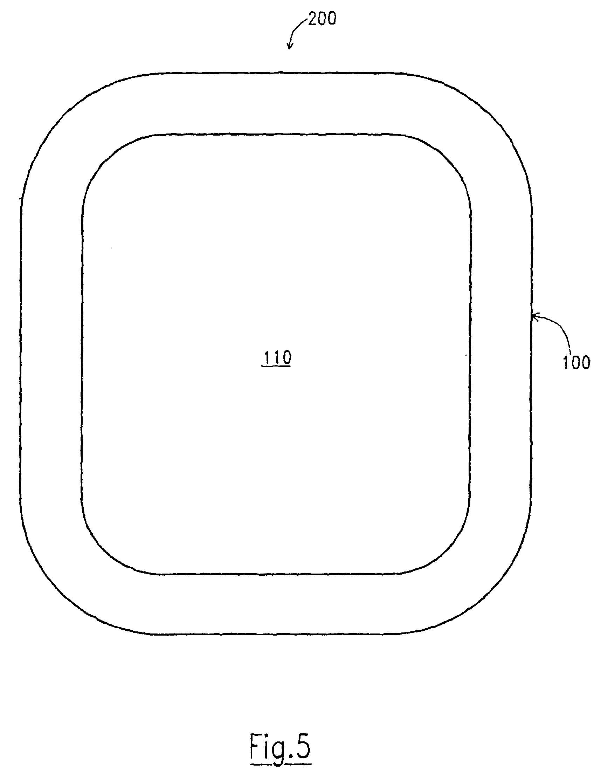

Figure 5 shows a schematic view of the chip 200 of the device comprising a MOSFET power transistor in the region 110 with the edge terminations 100 placed all around the zone 110 and extending along the periphery of the chip 200.

The manufacturing of such edge terminations 100 does not require supplementary steps. Also the manufacturing sequence of the device I provides for the formation of the heavily doped silicon regions after the formation of the gate oxide, in order to reduce the defects in the same oxide due to the contact with very high doped silicon regions by a thermal and deposition process.

## Claims

1. Semiconductor device for high voltages comprising at least one power component (21) and at least one edge termination (100), said edge termination (100) comprising a voltage divider including a plurality of capacitors (C7, C8, C9, C10, C11, C12) in series, said plurality of capacitors being formed by couples of said capacitors (C7, C8, C9, C10, C11, C12) formed by metal layers (71; 72) of a first level and polysilicon layers (11) of a second level interposed from a dielectric layer (8) underlying said metal layers (71; 72), said metal layers (71; 72) being alternated to said polysilicon layers (11) but extending in part over a zone of said dielectric layer (8) superimposed on said polysilicon layers (11), **characterized in that** said edge termination (100) is connected between non-drivable terminals of said power component (21), the last capacitor of the series of capacitors (e7, e8, e9, e10, e11, e12,) being coupled with one of said non-drivable terminals by means of a diode (41), where in said diode is connected between said last capacitor and said one of said non-drivable terminals.

2. Semiconductor device for high voltages according to claim 1, **characterized in that** some first silicon stripes (5; 50) of a second conductivity type are provided inside a silicon layer (10) of a first conductivity type, said stripes are placed in a zone underlying to said metal layers (71) and are comprised in zones corresponding at the end of a first of said polysilicon layers (11) and at the beginning of a second of said polysilicon layers (11).

3. Semiconductor device for high voltages according to claim 2, **characterized in that** said edge terminations (100) are placed in a chip (200) all around a zone (110) where said power transistor (21) is located, and extending along the periphery of said chip (200).

4. Semiconductor device for high voltages according to claim 3, **characterized in that** said couples of said capacitors (C7, C8, C9, C10, C11, C12) are alternated by capacitors in shunt (C2, C3, C4, C5) formed by said polysilicon layers (11), by portions (20) of said silicon layer (10) of a first conductivity type underlying to said polysilicon layers (11), and by a silicon oxide layer (9) placed between said polysilicon layers (11) and said portions (20) of said silicon layer (10) of a first conductivity type.

5. Semiconductor device for high voltages according to claim 4, **characterized in that** said power component (21) is a MOSFET transistor.

6. Semiconductor device for high voltages according to claim 5, **characterized in that** said silicon oxide layer (9) shows in a its peripheral part a thin thickness region (91) overlapping a second silicon stripe (4) of a second conductivity type representing the body region of the MOSFET transistor (21), said thin thickness region (91) of silicon oxide (9) being underlying a first of said polysilicon layers (11).

7. Semiconductor device for high voltages according to claim 6, **characterized in that** said first of said polysilicon layers (11) represents the gate of said MOSFET transistor (21).

8. Semiconductor device for high voltages according to claim 7, **characterized in that** inside said body region (4) of said MOSFET transistor (21) a silicon region (3) of a first conductivity type is provided which represents the source region of said MOSFET transistor (21) and is electrically contacted with the same body region (4) of said MOSFET transistor (21)

9. Semiconductor device for high voltages according to claim 8, **characterized in that** in breakdown state the MOSFET transistor (21) is off causing that said gate of MOSFET transistor (21) and said source region (3) of said MOSFET transistor (21) assume substantially a same potential.

## Patentansprüche

1. Halbleitervorrichtung für hohe Spannungen mit wenigstens einem Leistungsbauelement (21) und wenigstens einem Randabschlusswiderstand (100), wobei der Randabschlusswiderstand (100) einen Spannungsteiler aufweist, der eine Vielzahl von Kondensatoren (C7, C8, C9, C10, C11, C12) in einer Reihe enthält, wobei die Vielzahl von Kondensatoren durch Paare der Kondensatoren (C7, C8, C9, C10, C11, C12) gebildet ist, die durch metallische Schichten (71; 72) einer ersten Ebene und Polysiliziumschichten (11) einer zweiten Ebene gebildet sind, zwischen welchen einen dielektrische Schicht (8) angeordnet ist, die unter den metallischen Schichten (71; 72) liegt, wobei die metallischen Schichten (71; 72) abwechselnd zu den Polysiliziumschichten (11) sind, sich aber teilweise über eine Zone der dielektrischen Schicht (8) ausdehnen, die den Polysiliziumschichten (11) überlagert ist, **dadurch gekennzeichnet, dass** der Randabschlusswiderstand (100) zwischen nicht antreibbaren Anschlüssen des Leistungsbauelements (21) angeschlossen ist, wobei der letzte Kondensator der Reihe von Kondensatoren (C7, C8, C9, C10, C11, C12) mittels einer Diode (41) mit einem der nicht antreibbaren Anschlüsse gekoppelt ist, wobei die Diode zwischen dem letzten Kondensator und dem einen der nicht antreibbaren Anschlüsse angeschlossen ist.

2. Halbleitervorrichtung für hohe Spannungen nach Anspruch 1, **dadurch gekennzeichnet, dass** einige erste Siliziumstreifen (5; 50) eines zweiten Leitfähigkeitstyps innerhalb einer Siliziumschicht (10) eines ersten Leitfähigkeitstyps vorgesehen sind, die Streifen in einer Zone angeordnet sind, die unter den metallischen Schichten (71) liegt, und in Zonen entsprechend am Ende einer ersten der Polysiliziumschichten (11) und am Anfang einer zweiten der Polysiliziumschichten (11) umfasst sind.

3. Halbleitervorrichtung für hohe Spannungen nach Anspruch 2, **dadurch gekennzeichnet, dass** die Widerstandsabschlüsse (100) in einem Chip (200) um die Gesamtheit einer Zone (110) angeordnet sind, wo der Leistungstransistor (21) angeordnet ist, und sich entlang der Peripherie des Chips (200) ausdehnen.

4. Halbleitervorrichtung für hohe Spannungen nach Anspruch 3, **dadurch gekennzeichnet, dass** zu den Paaren der Kondensatoren (C7, C8, C9, C10, C11, C12) Kondensatoren (C2, C3, C4, C5) parallel dazu abwechselnd sind, die durch die Polysiliziumschichten (11), durch Teilabschnitte (20) der Siliziumschicht (10) eines ersten Leitfähigkeitstyps, die unter den Polysiliziumschichten (11) liegen, und durch eine Siliziumoxidschicht (9), die zwischen den Polysiliziumschichten (11) und den Teilabschnitten (20) der Siliziumschicht (10) eines ersten Leitfähigkeitstyps angeordnet sind, gebildet sind.

5. Halbleitervorrichtung für hohe Spannungen nach Anspruch 4, **dadurch gekennzeichnet, dass** das Leistungsbauelement (21) ein MOSFET-Transistor ist.

6. Halbleitervorrichtung für hohe Spannungen nach Anspruch 5, **dadurch gekennzeichnet, dass** die Siliziumoxidschicht (9) in ihrem peripheren Teil einen Bereich dünner Dicke (91) zeigt, der einen zweiten Siliziumstreifen (4) eines zweiten Leitfähigkeitstyps überlagert, der den Körperbereich des MOSFET-Transistors (21) darstellt, wobei der Bereich dünner Dicke (91) aus Siliziumoxid (9) unter einer ersten der Polysiliziumschichten (11) liegt.

7. Halbleitervorrichtung für hohe Spannungen nach Anspruch 6, **dadurch gekennzeichnet, dass** die erste der Polysiliziumschichten (11) das Gate des MOSFET-Transistors (21) darstellt.

8. Halbleitervorrichtung für hohe Spannungen nach Anspruch 7, **dadurch gekennzeichnet, dass** innerhalb des Körperbereichs (4) des MOSFET-Transistors (21) ein Siliziumbereich (3) eines ersten Leitfähigkeitstyps vorgesehen ist, der mit demselben Körperbereich (4) des MOSFET-Transistors (21) elektrisch in Kontakt ist.

9. Halbleitervorrichtung für hohe Spannungen nach Anspruch 8, **dadurch gekennzeichnet, dass** ein Durchbruchzustand des MOSFET-Transistors (21) im Aus-Zustand ist, was veranlasst, dass das Gate des MOSFET-Transistors (21) und der Sourcebereich (3) des MOSFET-Transistors (21) im Wesentlichen dasselbe Potential annehmen.

## Revendications

1. Dispositif semiconducteur pour hautes tensions comprenant au moins un composant de puissance (21) et au moins une terminaison de bord (100), ladite terminaison de bord (100) comprenant un diviseur de tension incluant plusieurs condensateurs (C7, C8, C9, C10, C11, C12) en série, les condensateurs étant formés de couples de condensateurs (C7, C8, C9, C10, C11, C12) formés par des couches métalliques (71, 72) d'un premier niveau et par des couches de polysilicium (11) d'un second niveau interposées à partir d'une couche diélectrique (8) s'étendant sous les couches métalliques (71, 72), lesdites couches métalliques (71, 72) étant alternées avec les couches de polysilicium (11) mais s'étendant en partie sur une zone de la couche diélectrique (8) superposée aux couches de polysilicium (11), **caractérisé en ce que** ladite terminaison de bord (100) est connectée entre des bornes non pilotables dudit composant de puissance (21), le dernier condensateur de la série de condensateurs (C7, C8, C9, C10, C11, C12) étant couplé avec l'une des bornes non pilotables par des moyens formant diode (41), ladite diode étant connectée entre ledit dernier condensateur et ladite borne non pilotable.

2. Dispositif semiconducteur pour hautes tensions selon la revendication 1, **caractérisé en ce que** quelques premières bandes de silicium (5, 50) ayant un second type de conductivité sont disposées à l'intérieur d'une couche de silicium (10) ayant un premier type de conductivité, lesdites bandes étant placées dans une zone s'étendant sous les couches de métal (71) et sont comprises dans des zones correspondant à l'extrémité d'une première desdites couches de polysilicium (11) et au début d'une deuxième desdites couches de polysilicium (11).

3. Dispositif semiconducteur pour hautes tensions selon la revendication 2, **caractérisé en ce que** les terminaisons de bord (100) sont placées dans une puce (200) tout autour d'une zone (110) dans laquelle est situé ledit transistor de puissance (21), et s'étendant le long de la périphérie de ladite puce (200).

4. Dispositif semiconducteur pour hautes tensions selon la revendication 3, **caractérisé en ce que** les couples de condensateurs (C7, C8, C9, C10, C11, C12) sont alternés avec des condensateurs en dérivation (C2, C4, C5) formés par lesdites couches de polysilicium (11), par des portions (20) de ladite couche de silicium (10) d'un premier type de conductivité s'étendant sous les couches de polysilicium (11), et par une couche d'oxyde de silicium (9) placée entre les couche de polysilicium (11) et lesdites portions (20) de ladite couche de silicium (10) ayant le premier type de conductivité.

5. Dispositif semiconducteur pour hautes tensions selon la revendication 4, **caractérisé en ce que** le composant de puissance (21) est un transistor MOSFET.

6. Dispositif semiconducteur pour hautes tensions selon la revendication 5, **caractérisé en ce que** la couche d'oxyde de silicium (9) montre à sa partie périphérique une région de faible épaisseur (91) chevauchant un second ruban de silicium (4) d'un second type de conductivité représentant la région de substrat du transistor MOSFET (21), ladite région de faible épaisseur (91) d'oxyde de silicium (9) s'étendant sous une première desdites couches de polysilicium (11).

7. Dispositif semiconducteur pour hautes tensions selon la revendication 6, **caractérisé en ce que** ladite première desdites couches de polysilicium (11) représente la grille dudit transistor MOSFET (21).

8. Dispositif semiconducteur pour hautes tensions selon la revendication 7, **caractérisé en ce qu'**à l'intérieur de ladite région le substrat (4) du transistor MOSFET (21) est disposée une région de silicium (3) d'un premier type de conductivité, laquelle représente la région de source dudit transistor MOSFET (21), et est en contact électrique avec la même région de substrat (4) dudit transistor MOSFET (21).

9. Dispositif semiconducteur pour hautes tensions selon la revendication 8, **caractérisé en ce que** dans l'état de rupture, le transistor MOSFET (21) est bloqué de sorte que ladite grille du transistor MOSFET (21) et ladite région de source (3) du transistor MOSFET (21) présentent sensiblement un même potentiel.
